# EUROPÄISCHE PATENTSCHRIFT

(11) **EP 3 891 533 B1**
(45) Veröffentlichungstag und Bekanntmachung des Hinweises auf die Patenterteilung: **10.09.2025**
(21) Anmeldenummer: 19817151.4
(22) Anmeldetag: 28.11.2019
(51) Int. Cl.: G01V 3/165, G01V 3/08

(54) **ANZEIGEMITTEL ZUM ANZEIGEN DER STÄRKE EINES WECHSELMAGNETFELDS EINES PRIMÄRLEITERS**
INDICATOR MEANS FOR INDICATING THE INTENSITY OF AN ALTERNATING MAGNETIC FIELD OF A PRIMARY CONDUCTOR
MOYEN D'AFFICHAGE POUR AFFICHER L'INTENSITÉ D'UN CHAMP MAGNÉTIQUE ALTERNATIF D'UN CONDUCTEUR PRIMAIRE

(30) Priorität: 07.12.2018 DE 102018009528
(43) Veröffentlichungstag der Anmeldung: 13.10.2021
(73) Patentinhaber: SEW-Eurodrive GmbH & Co, 76646 Bruchsal (DE)
(72) Erfinder: BÖCKLE, Jürgen, 76646 Bruchsal (DE); GEISSLER, Michael, 76709 Kronau (DE); KIST, Alexander, 76131 Karlsruhe (DE); KUTZ, Michael, 76661 Philippsburg (DE); SCHMIDT, Josef, 76676 Graben-Neudorf (DE); SCHWESINGER, Klaus, 76646 Bruchsal (DE)
(86) Internationale Anmeldenummer: PCT/EP2019/025423
(87) Internationale Veröffentlichungsnummer: WO 2020/114627

(56) Entgegenhaltungen:
- EP-A1- 2 053 426
- WO-A1-2012/143082
- WO-A1-2015/087736
- DE-B3- 102015 012 439
- US-A- 2 931 974
- US-A1- 2014 139 223
- SURAJIT DAS BARMAN ET AL: "Wireless powering by magnetic resonant coupling: Recent trends in wireless power transfer system and its applications", RENEWABLE AND SUSTAINABLE ENERGY REVIEWS., vol. 51, November 2015 (2015-11-01), US, pages 1525 - 1552, XP055672293, ISSN: 1364-0321, DOI: 10.1016/j.rser.2015.07.031

## Beschreibung

Die Erfindung betrifft ein Anzeigemittel zum Anzeigen der Stärke eines Wechselmagnetfelds eines Primärleiters.

Es ist allgemein bekannt, dass ein Wechselmagnetfeld in einer Spule eine Wechselspannung induziert.

**Aus der** US 4 775 832 A **ist ein Anzeigemittel zum Anzeigen der Stärke eines Wechselmagnetfeldes eines Primärleiters bekannt, wobei das Anzeigemittel einen Schwingkreis aufweist.**

**Aus der** DE 32 35 535 A1 **ist ein Anzeigemittel zur Ortung metallsicher Gegenstände und zum Anzeigen der Stärke elektrischer Wechselfelder eines Primärleiters mittels eines Schwingkreises bekannt.**

**Aus der** EP 0 551 606 A2 **ist ein Metallsuchgerät mit einem Schwingkreis bekannt.**

**Aus der** DE 10 2015 012 439 B3 **ist als nächstliegender Stand der Technik ein System zur induktiven Übertragung elektrischer Energie von einer Primärwicklung an die Sekundärwicklung eines auf einem Boden verfahrbaren Fahrzeugs bekannt.**

**Aus der XP 055672293 ist ein kabelloses resonantes Pbertragen elektrischer Energie bekannt.**

**Aus der** US 2 931 974 A **ist ein geophysikalisches Erkundungsverfahren bekannt.**

**Aus der** WO 2012/143082 A1 **ist ein System zur induktiven Energieübertragung an einen Verbraucher bekannt.**

**Aus der** US 2014/139223 A1 **ist eine Feldgradientenantenne bekannt.**

**Aus der** WO 2015/087736 A1 **ist eine magnetische Detektionseinrichtung bekannt.**

**Aus der** EP 2 053 426 A1 **ist eine Anzeigeeinheit für einen Metalldetektor bekannt.**

Der Erfindung liegt daher die Aufgabe zugrunde, ein Anzeigemittel auszubilden.

Erfindungsgemäß wird die Aufgabe bei dem Anzeigemittel nach den in Anspruch 1 angegebenen Merkmalen gelöst.

Wichtige Merkmale der Erfindung bei dem Anzeigemittel zum Anzeigen der Stärke eines Wechselmagnetfelds eines Primärleiters sind, dass das Anzeigemittel ein oder mehrere Leuchtmittel aufweist,
**wobei das Anzeigemittel ein Gehäuse aufweist, welches ebene Oberflächenabschnitte aufweist, deren jeweilige Normalenrichtung zueinander nicht parallel ausgerichtet sind, insbesondere wobei oder wobei das Anzeigemittel ein Würfel-förmiges, Quader-förmiges Tetraeder-förmiges oder Polyederförmiges Gehäuse aufweist,**
wobei das Anzeigemittel eine mit einer Kapazität einen Schwingkreis bildende Induktivität aufweist,
wobei das oder die Leuchtmittel aus dem Schwingkreis versorgbar sind.

Von Vorteil ist dabei, dass das Anzeigemittel keinen Energiespeicher benötigt und spezifisch auf die Resonanzfrequenz des Schwingkreises reagiert. Somit wird nur die Stärke des Wechselmagnetfeldes bei der Resonanzfrequenz detektiert. Das Anzeigemittel ist also als Indikator zur Erkennung eines Betriebszustands in einer Anlage einsetzbar.

Bei einer vorteilhaften Ausgestaltung ist der Schwingkreis ein Parallelschwingkreis oder ein Reihenschwingkreis. Von Vorteil ist dabei, dass entsprechend große Spannung zur Verfügung stellbar ist.

**Erfindungsgemäß** weist die Induktivität einen Spulenkern und eine darum gewickelte Spulenwicklung auf. Von Vorteil ist dabei, dass die Induktivität einfach herstellbar ist.

**Erfindungsgemäß** weist der Spulenkern drei, jeweils zu den anderen beiden senkrecht ausgerichteten Kernteilen auf, wobei um jeden der Kernteile eine Teilwicklung der Spulenwicklung gewickelt ist,
wobei die Spulenwicklung aus den in Reihe miteinander verschalteten Teilwicklungen gebildet ist. Von Vorteil ist dabei, dass die Stärke des Magnetfelds unabhängig von der Ausrichtung der Anzeigeeinheit detektierbar ist.

Bei einer vorteilhaften Ausgestaltung ist das Gehäuse aus einem optisch transparenten Material gebildet. Von Vorteil ist dabei, dass das Leuchtmittel im Gehäuseinneren anordenbar ist.

Bei einer vorteilhaften Ausgestaltung ist das oder das jeweilige Leuchtmittel jeweils in einer durch das Gehäuse durchgehenden Ausnehmung angeordnet. Von Vorteil ist dabei, dass eine einfache Herstellung ermöglicht ist.

Bei einer vorteilhaften Ausgestaltung ist das jeweilige Leuchtmittel im vom Gehäuse umgebenen Gehäuseinneren angeordnet. Von Vorteil ist dabei, dass das Leuchtmittel einfach schützbar ist.

Bei einer vorteilhaften Ausgestaltung sind das oder die Leuchtmittel, insbesondere nur, aus dem Schwingkreis versorgt. Von Vorteil ist dabei, dass kein Energiespeicher, wie Batterie oder Akkumulator, für das Anzeigemittel notwendig ist.

Wichtige Merkmale bei der Anlage mit vorgenanntem Anzeigemittel sind, dass ein als Linienleiter ausgeführter, mit Wechselstrom beaufschlagter Primärleiter in einem Boden der Anlage verlegt ist, insbesondere also unterhalb einer Bodenebene,
wobei das Anzeigemittel auf der Oberfläche des Bodens, insbesondere auf der Bodenebene, angeordnet ist.

Von Vorteil ist dabei, dass mittels des Anzeigemittels der Linienleiter detektierbar ist, wenn er mit einem Wechselstrom beaufschlagt ist, dessen Frequenz der Resonanzfrequenz des Schwingkreises des Anzeigemittels gleicht.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:
In der Figur 1 ist eine Anzeigeeinheit in zwei verschiedenen Abständen zu einem Primärleiter 3 gezeigt.
In der Figur 2 ist eine erste elektronische Schaltung der Anzeigeeinheit schematisch skizziert.
In der Figur 3 ist eine alternative zweite elektronische Schaltung der Anzeigeeinheit schematisch skizziert.

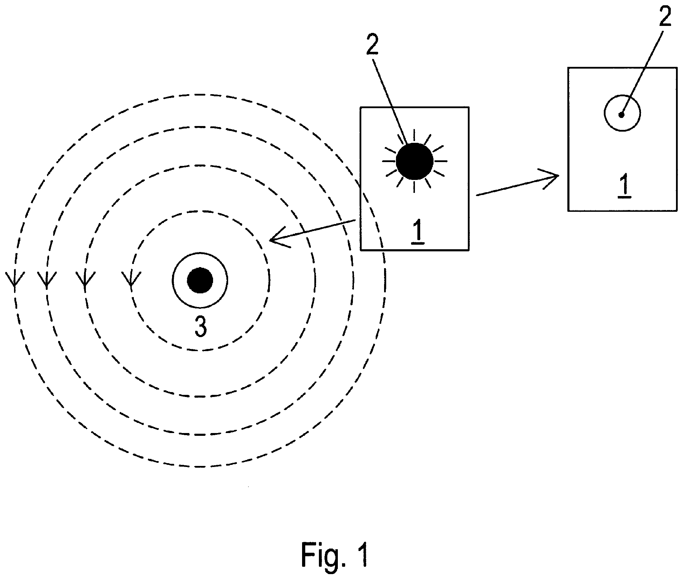

Wie in Figur 1 dargestellt, weist eine Anlage einen langgestreckt verlegten Primärleiter 3 auf, dessen Magnetfeld in Figur 1 schematisch dargestellt ist. Die Anzeigeeinheit weist als Leuchtmittel eine LED 2 auf, die bei großem Abstand vom Primärleiter 3 nicht leuchtet und bei kleinerem Abstand zum Primärleiter 3 leuchtet.

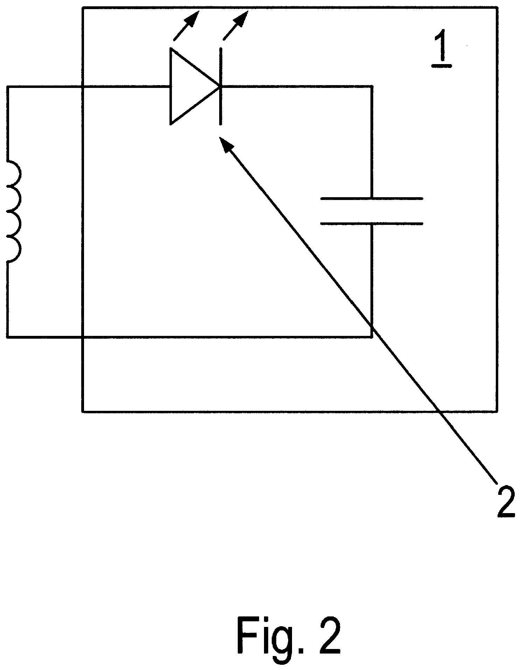

Dies wird mit der in Figur 2 gezeigten elektronischen Schaltung erreicht, welche im Anzeigemittel angeordnet ist.

Wie in Figur 2 dargestellt, ist eine Induktivität vorgesehen, welche induktiv koppelbar ist mit dem Primärleiter 3, so dass an den Anschlüssen der Induktivität eine induzierte Spannung bereit stellbar ist, wenn die Kopplung an den Primärleiter genügend stark ist, insbesondere also der Abstand einen Schwellwert unterschreitet.

Aus der von der Induktivität bereit stellbaren Spannung ist eine aus dem Leuchtmittel und einem Kondensator gebildete Reihenschaltung versorgbar.

Dabei sind die Induktivität und die Kapazität derart dimensioniert, dass der bei Vernachlässigung des Leuchtmittels so gebildete Reihenschwingkreis eine Resonanzfrequenz aufweist, welche der Frequenz des in den Primärleiter eingeprägten Wechselstromes gleicht.

Sobald also das vom Primärleiter erzeugte Magnetfeld am Ort der Induktivität der Anzeigeeinheit einen ersten Schwellwert überschreitet, leuchtet das Leuchtmittel.

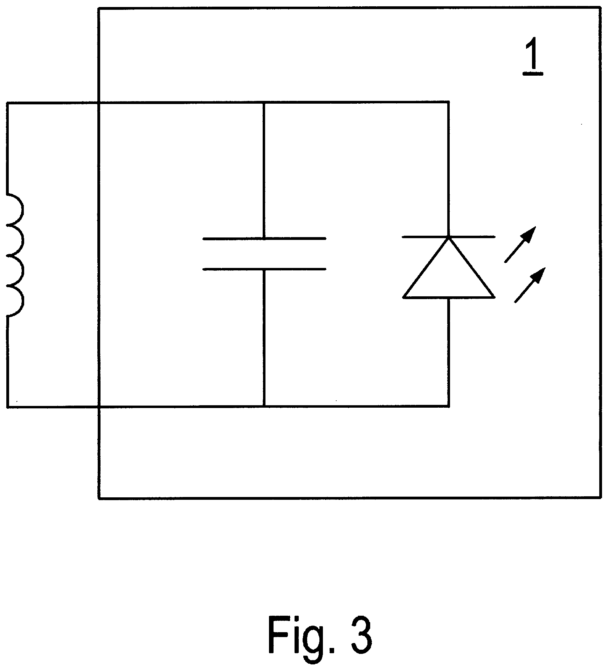

Beim alternativen Ausführungsbeispiel nach Figur 3 ist statt des Reihenschwingkreises nach Figur 2 ein Parallelschwingkreis vorgesehen. Hierbei sind das Leuchtmittel, die Induktivität sowie die Kapazität zueinander parallelgeschaltet.

Die Ausführungsbeispiele nach Figur 2 und Figur 3 schalten bei unterschiedlichen Magnetfeldstärken das Leuchtmittel an, weil verschiedene Spannungen von dem Reihenschwingkreis oder Parallelschwingkreis bei gleichstarkem Wechselmagnetfeld bereitgestellt werden.

Die Anzeigeeinheit weist ein würfelförmiges oder zumindest quaderförmiges Gehäuse auf. Somit ist die Induktivität durch eine Spule bereit stellbar, deren vorzugsweise aus Ferrit gefertigter Spulenkern in wohldefinierte Lage zum Primärleiter bringbar ist, da die Anzeigeeinheit auf dem Boden auflegbar ist.

Der Primärleiter 3 ist als langgestreckter Linienleiter im Boden verlegt, also angeordnet. Somit ist der Primärleiter 3 unterhalb der Bodenebene angeordnet, auf welche die Anzeigeeinheit positionierbar ist. Beim Annähern an den Primärleiter 3, also bei Verringerung des Abstands und Stärkerwerden des Magnetfelds, beginnt das Leuchtmittel ab einer bestimmten Position zu leuchten.

Vorzugsweise wird die Anzeigeeinheit, insbesondere auf der Bodenebene, entlang derjenigen Ebene verschoben, deren Normalenrichtung parallel zur Richtung des Linienleiters, also Primärleiters 3, ausgerichtet ist. Die auf den Primärleiter 3 bezogene, relative räumliche Ausrichtung der Anzeigeeinheit bleibt dabei stets gleich.

Da die Induktivität mit der Kapazität einen Serienschwingkreis bei Figur 2 oder einen Parallelschwingkreis bei Figur 3 bilden.

Das Leuchtmittel 2 ist in einer durch das Gehäuse durchgehenden Ausnehmung angeordnet.

Bei weiteren erfindungsgemäßen Ausführungsbeispielen ist das Gehäuse der Anzeigeeinheit ein Tetraeder.

Bei weiteren erfindungsgemäßen Ausführungsbeispielen sind an jeder der Seitenflächen des Polyeder-förmigen Gehäuses jeweils ein Leuchtmittel angeordnet, insbesondere wobei die Leuchtmittel entweder in Reihe oder parallelgeschaltet sind. Die Leuchtmittel beginnen dann gleichzeitig zu leuchten, wenn ein genügend starkes Magnetfeld vorhanden ist.

Bei weiteren erfindungsgemäßen Ausführungsbeispielen wird das Gehäuse aus einem optisch transparenten Material ausgeführt, so dass das oder die Leuchtmittel im Inneren der Anzeigeeinheit anordenbar sind.

Bei weiteren erfindungsgemäßen Ausführungsbeispielen sind am Gehäuse ein erstes und ein zweites Leuchtmittel angeordnet, wobei die elektronische Schaltung derart ausgeführt ist, dass das erste Leuchtmittel leuchtet, wenn die Stärke des Wechselmagnetfelds zwischen einem ersten und einem zweiten schwellwert liegt. Das zweite Leuchtmittel leuchtet aber erst, wenn die Stärke des Wechselmagnetfelds oberhalb des zweiten Leuchtmittels liegt.

Dabei ist der zweite Schwellwert betragsmäßig größer als der zweite schwellwert.

### Bezugszeichenliste

1 Gehäuseteil
2 LED
3 Primärleiter

## Patentansprüche

1. Anzeigemittel zum Anzeigen der Stärke eines Wechselmagnetfelds eines Primärleiters (3),
wobei das Anzeigemittel ein oder mehrere Leuchtmittel (2) aufweist,
wobei das Anzeigemittel eine mit einer Kapazität einen Schwingkreis bildende Induktivität aufweist,
wobei das oder die Leuchtmittel (2) aus dem Schwingkreis versorgbar sind,
**dadurch gekennzeichnet, dass**
das Anzeigemittel ein Gehäuse (1) aufweist, welches ebene Oberflächenabschnitte aufweist, deren jeweilige Normalenrichtung zueinander nicht parallel ausgerichtet sind,
**wobei die Induktivität einen Spulenkern und eine darum gewickelte Spulenwicklung aufweist.**
**wobei der Spulenkern drei, jeweils zu den anderen beiden senkrecht ausgerichteten Kernteilen aufweist, wobei um jeden der Kernteile eine Teilwicklung der Spulenwicklung gewickelt ist,**
**wobei die Spulenwicklung aus den in Reihe miteinander verschalteten Teilwicklungen gebildet ist.**

2. **Anzeigemittel nach Anspruch 1,**
**dadurch gekennzeichnet, dass**
**das Anzeigemittel ein Würfel-förmiges, Quader-förmiges Tetraeder-förmiges oder Polyederförmiges Gehäuse (1) aufweist.**

3. Anzeigemittel nach Anspruch 1 oder 2,
**dadurch gekennzeichnet, dass**
**aus der von der Induktivität bereit stellbaren Spannung eine aus dem oder aus einem der Leuchtmittel (2) und der als Kondensator ausgeführten Kapazität gebildete Reihenschaltung versorgbar ist,**
**wobei der Schwingkreis eine Resonanzfrequenz aufweist, welche der Frequenz des in den Primärleiter (3) eingeprägten Wechselstromes gleicht.**

4. Anzeigemittel nach einem der vorangegangenen Ansprüche,
**dadurch gekennzeichnet, dass**
das Gehäuse (1) aus einem optisch transparenten Material gebildet ist.

5. Anzeigemittel nach einem der vorangegangenen Ansprüche,
**dadurch gekennzeichnet, dass**
das oder das jeweilige Leuchtmittel (2) jeweils in einer durch das Gehäuse (1) durchgehenden Ausnehmung angeordnet ist
oder dass
das jeweilige Leuchtmittel (2) im vom Gehäuse (1) umgebenen Gehäuseinneren angeordnet ist.

6. Anzeigemittel nach einem der vorangegangenen Ansprüche,
**dadurch gekennzeichnet, dass**
das oder die Leuchtmittel nur, aus dem Schwingkreis versorgt sind.

7. Anlage mit Anzeigemittel nach einem der vorangegangenen Ansprüche,
**dadurch gekennzeichnet, dass**
ein als Linienleiter ausgeführter, mit Wechselstrom beaufschlagter Primärleiter (3) in einem Boden der Anlage verlegt ist, insbesondere also unterhalb einer Bodenebene,
wobei das Anzeigemittel auf der Oberfläche des Bodens, insbesondere auf der Bodenebene, angeordnet ist.

## Claims

1. Display means for displaying the strength of an alternating magnetic field of a primary conductor (3),
wherein the display means has one or more illumination means (2),
wherein the display means has an inductor that forms a resonant circuit together with a capacitor,
wherein the one illumination means or the plurality of illumination means (2) can be powered from the resonant circuit,
**characterised in that**
the display means has a housing (1) that has planar surface portions, the respective normal directions of which are not oriented in parallel with one another,
wherein the inductor has a coil core and a coil winding wound around said coil core,
wherein the coil core has three core parts, each oriented perpendicularly to the other two,
wherein one part-winding of the coil winding is wound around each of the core parts,
wherein the coil winding is formed from the part-windings, which are connected in series with one another.

2. Display means according to claim 1,
**characterised in that**
the display means has a cube-shaped, parallelepiped-shaped, tetrahedron-shaped or polyhedron-shaped housing (1).

3. Display means according to claim 1 or claim 2,
**characterised in that**
a series circuit, formed of the one illumination means or of one of the plurality of illumination means (2) and the capacitor, which is configured as a condenser, can be powered from the voltage that can be provided by the inductor,
wherein the resonant circuit has a resonant frequency that is equal to the frequency of the alternating current impressed on the primary conductor (3).

4. Display means according to any of the preceding claims,
**characterised in that**
the housing (1) is made of an optically transparent material.

5. Display means according to any of the preceding claims,
**characterised in that**
the one illumination means or the plurality of illumination means (2) is/are in each case arranged in a through-opening that extends through the housing (1)
or **in that**
each illumination means (2) is arranged in the housing interior enclosed by the housing (1).

6. Display means according to any of the preceding claims,
**characterised in that**
the one illumination means or the plurality of illumination means is/are powered solely from the resonant circuit.

7. Facility comprising a display means according to any of the preceding claims,
**characterised in that**
a primary conductor (3) which is in the form of a line conductor and to which alternating current is applied is installed in a floor of the facility, i.e. in particular below a floor level,
wherein the display means is arranged on the surface of the floor, in particular on the floor level.

## Revendications

1. Moyen d'affichage permettant d'afficher l'intensité d'un champ magnétique alternatif d'un conducteur primaire (3),
le moyen d'affichage présentant une ou plusieurs lampe(s) (2),
le moyen d'affichage présentant une inductance formant avec une capacité un circuit oscillant,
la ou les lampe(s) (2) pouvant être alimentée(s) à partir du circuit oscillant,
**caractérisé en ce que**
le moyen d'affichage présente un boîtier (1) qui présente des sections de surface planes dont les directions normales respectives ne sont pas orientées parallèlement les unes aux autres,
l'inductance présentant un noyau de bobine et un enroulement de bobine enroulé autour du dit noyau,
le noyau de la bobine présentant trois parties de noyau respectivement orientées de manière perpendiculaire aux deux autres, un enroulement partiel de l'enroulement de bobine étant enroulé autour de chacune des parties de noyau,
l'enroulement de bobine étant formé par les enroulements partiels interconnectés en série.

2. Moyen d'affichage selon la revendication 1,
**caractérisé en ce que**
le moyen d'affichage présente un boîtier (1) en forme de cube, en forme de parallélépipède, en forme de tétraèdre ou en forme de polyèdre.

3. Moyen d'affichage selon la revendication 1 ou 2,
**caractérisé en ce que**
un circuit en série, formé par la lampe ou l'une des lampes (2) et la capacité mise en œuvre sous la forme d'un condensateur, peut être alimenté par la tension pouvant être fournie par l'inductance,
le circuit oscillant présentant une fréquence de résonance égale à la fréquence du courant alternatif introduit dans le conducteur primaire (3).

4. Moyen d'affichage selon l'une quelconque des revendications précédentes, **caractérisé en ce que**
le boîtier (1) est formé à partir d'un matériau optiquement transparent.

5. Moyen d'affichage selon l'une quelconque des revendications précédentes,
**caractérisé en ce que**
la lampe ou la lampe respective (2) est agencée respectivement dans un évidement traversant le boîtier (1)
ou **en ce que**
la lampe respective (2) est agencée dans l'intérieur de boîtier entouré par le boîtier (1).

6. Moyen d'affichage selon l'une quelconque des revendications précédentes,
**caractérisé en ce que**
la ou les lampe(s) ne sont alimentée(s) que par le circuit oscillant.

7. Installation comprenant un moyen d'affichage selon l'une quelconque des revendications précédentes,
**caractérisé en ce que**
un conducteur primaire (3), qui est mis en œuvre sous la forme d'un conducteur linéaire et est alimenté en courant alternatif, est posé dans un sol de l'installation, en particulier sous le niveau du sol,
le moyen d'affichage étant agencé à la surface du sol, en particulier au niveau du sol.
